Europäisches Patentamt

European Patent Office

Office européen des brevets

(11) Publication number : **0 481 806 A1**

(19)

(12) # EUROPEAN PATENT APPLICATION

(21) Application number : **91309625.1**

(22) Date of filing : **18.10.91**

(51) Int. Cl.⁵ : **H05K 5/00, F16F 15/08, G01D 11/16**

(30) Priority : **19.10.90 GB 9022737**
**28.06.91 GB 9114061**

(43) Date of publication of application :
**22.04.92 Bulletin 92/17**

(84) Designated Contracting States :
**BE DE ES FR GB IT NL SE**

(71) Applicant : **LUCAS INDUSTRIES PUBLIC LIMITED COMPANY**
**Brueton House, New Road**
**Solihull, West Midlands B91 3TX (GB)**

(72) Inventor : **Duncan, Ian Robert**
**4 Bowling Green Lane**
**Cirencester, Gloucester GL7 2DX (GB)**
Inventor : **Bliss, Matthew James**
**20 Park View**
**Stratton, Cirencester, Gloucester (GB)**

(74) Representative : **Gibson, Stewart Harry et al**
**URQUHART-DYKES & LORD Business**
**Technology Centre Senghennydd Road**
**Cardiff CF2 4AY South Wales (GB)**

(54) Component mounting arrangements.

(57) A component mounting arrangement comprises a substrate carrying at least one component (e.g. an acceleration sensor), a plurality of elastomeric elements (16) connected to the substrate and spaced apart around the periphery of the substrate, and a housing having a base portion (17), (17a) and a top portion (19) fitted together, the substrate being disposed within the housing with the elastomeric elements connected to the housing.

Figure 1

EP 0 481 806 A1

This invention relates to an arrangement for mounting an electrical or electronic component and is particularly but not solely concerned with acceleration sensors.

Acceleration sensors which are used to monitor forces to which a vehicle suspension system is subjected may comprise micromachined silicon structures as their sensing elements. Such sensing elements are typically required to sense accelerations from zero to many times normal gravity. Whilst these elements are designed to withstand such accelerations without damage, circumstances may occur during handling and in operation when very large accelerations (of the order of many thousand times normal gravity) are experienced e.g. if the sensor assembly is dropped onto a solid surface during handling. A requirement therefore exists for a form of packaging of the sensor and its associated electronic circuitry which will allow low-level accelerations to be transmitted to the sensing element without significant attenuation and will provide attenuation of high-level accelerations which would cause damage to the sensing element. The mounting structure is further required to provide a similar attenuation characteristic in both directions along the principal sensing axis.

In accordance with this invention, there is provided a component mounting arrangement, comprising a substrate carrying at least one component, a plurality of elastomeric elements connected to the substrate and spaced apart around the periphery of the substrate, and a housing having a base portion and a top portion fitted together, the substrate being disposed within the housing with the elastomeric elements connected to the housing.

The elastomeric elements may be held between the top and base portions of the housing by being under precompression, with or without the use of adhesive between the elements and the respective portions of the enclosure. Instead, the elastomeric elements may be held without precompression between the top and base portions of the housing, either being fixed by adhesive between themselves and the respective portions of the housing or located within recesses defined between the two portions of the housing. The housing may comprise a lid and a base which form the two portions between which the elastomeric elements are held.

The elastomeric elements may be engaged directly to the substrate, for example at its corners. The elastomeric elements may then be generally of U-shape, engaging around the edge of the substrate. Preferably a pad is fixed to a surface of the substrate at the location of each elastomeric element, to increase the thickness of the material which presses on the elastomeric element in the event of forces acting on the substrate in its own plane.

The substrate may be fixed rigidly to a support, with the elastomeric elements engaged to the support. The support may comprise a casing e.g. of metal or of plastics, which receives the substrate and has projections to which the elastomeric elements are engaged.

In embodiments to be described herein, the elastomeric elements are disposed in recesses which leave space for them to deform into when subjected to acceleration. The shape of the space relative to the respective element determines the response to accelerations. Instead the elastomeric elements may be disposed in the recesses without such space, if the application and material of the elements will allow.

In preferred embodiments, a plurality of projections or spigots extend outwardly from the substrate or from a casing in which the substrate is mounted, each such projection or spigot carrying an elastomeric element in the form of an O-ring. A major advantage of these embodiments derives from the relative ease with which O-rings can be manufactured to a high degree of concentricity. The O-rings may be engaged within recesses in respective mounting elements which are in turn engaged with the housing and preferably located in recesses in side walls of the base of the housing. In these embodiments, the substrate may be mounted within a die-cast casing with which the projections or spigots are integral: this arrangement enables good dimensional accuracy to be maintained and the substrate can be mounted to the casing at the required orientation without the use of a packing piece.

The invention may be used for mounting miniature accelerometers used on a vehicle suspension system. The stiffness/resilience characteristics of the elastomeric elements are chosen so that the resonant vibrational frequency of the structure which they support is substantially different from the frequencies to which the devices are normally subjected when used on a vehicle suspension system.

In the embodiments to be described, the elastomeric elements remain relatively rigid under low values of acceleration (at least along an axis perpendicular to the substrate), but exhibit substantial flexibility at higher values of acceleration. In one embodiment, the elastomeric elements are in the form of two cups arranged back to back: these retain their shape under accelerations up to a distinct value along the axis perpendicular to the substrate, and exhibit substantial flexibility and therefore attenuation for accelerations above that value.

Embodiments of this invention will now be described by way of examples only and with reference to the accompanying drawings, in which:

FIGURE 1 is a plan view of an acceleration sensor mounting arrangement with the lid of its housing removed;

FIGURE 2 is a cross-section through the housing of Figure 1;

FIGURE 3 is a section on the line III - III of Figure 1;

FIGURE 4 is a plan view of a second embodiment of sensor mounting arrangement with its lid removed;

FIGURE 5 is a section on the line V - V of Figure 4:

FIGURE 6 is a section on the line VI - VI of Figure 4;

FIGURE 7 is a part-section showing a modified elastomeric mounting element;

FIGURE 8 is a part-section through an injection mould for moulding the elastomeric mounting elements;

FIGURE 9 is a section corresponding to Figure 6, showing another form of elastomeric mounting element;

FIGURE 10 gives sections on enlarged scale through two alternatives for the elastomeric elements shown in Figure 9;

FIGURE 11 is a section corresponding to Figure 6, showing a further embodiment of sensor mounting arrangement in accordance with this invention;

FIGURE 12 is an underside view of the sensor mounting arrangement of Figure 11 with the base of its outer housing removed;

FIGURE 13 is an underside view of a yet further embodiment of sensor mounting arrangement, shown with the base of its outer housing removed; and

FIGURE 14 is a section through the mounting arrangement of Figure 13.

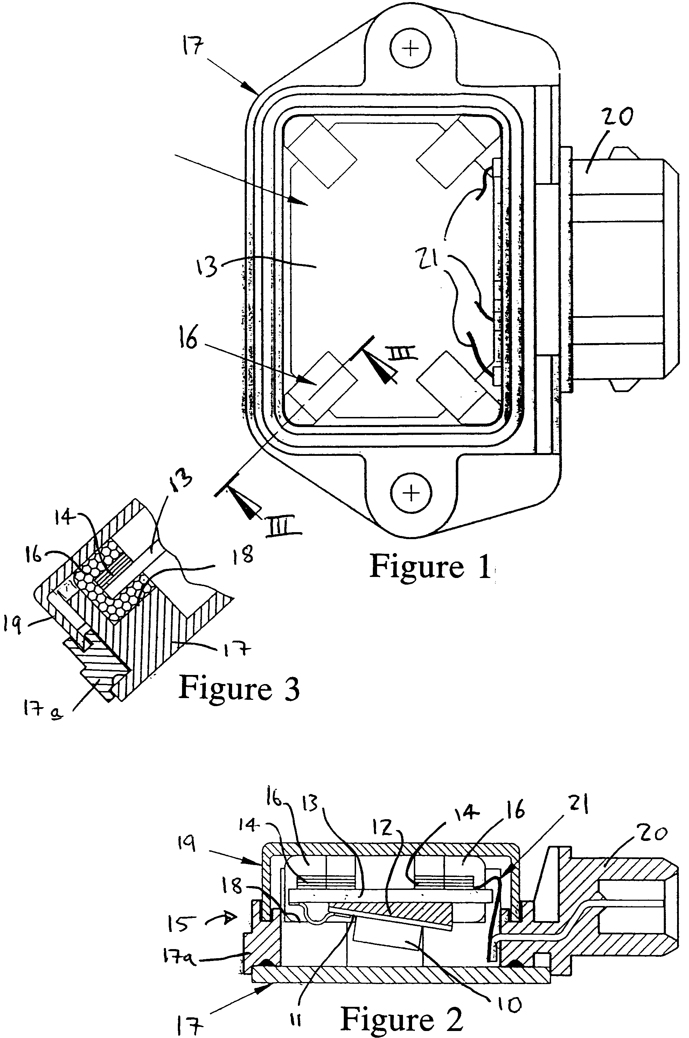

Referring to Figures 1 to 3, there is shown a mounting arrangement for a miniature acceleration sensor 10. This sensor 10 is fixed to a ceramic tile 11 which is fixed to a wedge-shaped packer 12 which is fixed to the underside of a generally rectangular substrate in the form of an electronic circuit board 13. The four corners of the circuit board 13 are cut away at 45°. Rectangular pads 14 are fixed to one surface of the board 13 at its corners. The board 13 is mounted within a housing 15 by four elastomeric elements 16 of foamed plastics, which are generally U-shaped and receive the respective corners and pads 14 of the board. The housing 15 comprises a base 17 having shoulders 18 in its corners, on which the elastomeric elements 16 rest, a peripheral frame 17a attached to the base 17, and a lid 19 which is fixed to the frame 17a by adhesive and which bears on the elastomeric elements 16. The elements 16 are lightly gripped between the lid 19 and base 17, and are constrained between the edges of the board 13 and the peripheral wall of the base, as shown in Figure 3. The frame 17a has a connector 20 projecting from one side and electrical leads e.g. 21 extend from the terminals of this connector to the circuit board 13. The pads 14 are of hard material and may if the board layout will allow comprise surface mounted electronic components:

otherwise they may comprise any convenient packing material. The pads 14 serve to increase the thickness of material which presses on the elastomeric elements 16 in the event of forces acting on the board in its own plane and thus reduce the displacement of the board in this plane.

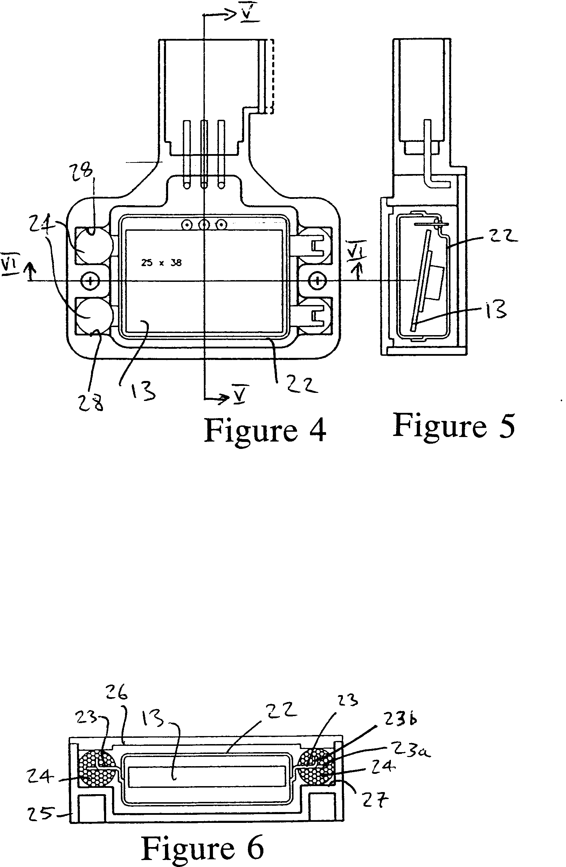

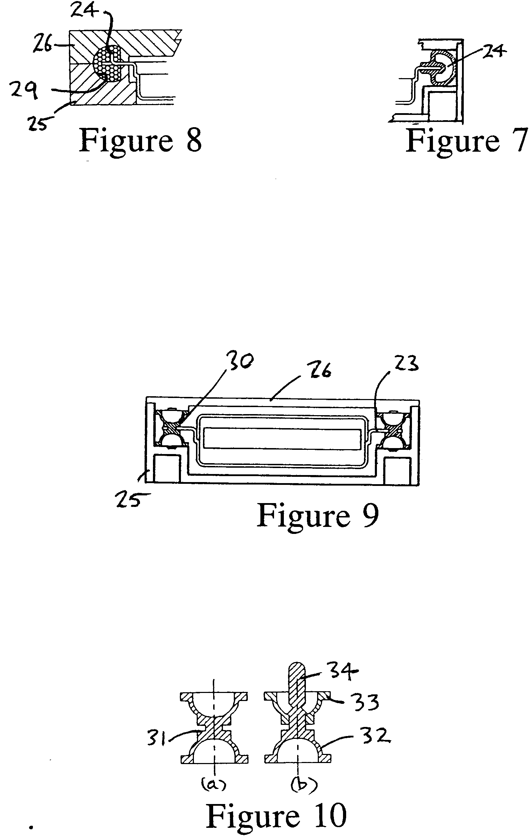

Referring to Figures 4 to 6, in a modified mounting arrangement the circuit board 13 carrying the acceleration sensor is rigidly fixed within a casing 22 which is formed from sheet metal but which instead may be formed of plastics. The casing 22 has a base part and a lid part, and the base part has projections 23 projecting outwardly from its top edge, two such projections being spaced-apart at one end of the casing and another two being similarly spaced-apart at the opposite end. Each projection 23 comprises a horizontal portion 23a and a vertical portion 23b, and receives an elastomeric element 24, which may be spherical as shown and comprise foamed plastics. The casing 22 is resiliently mounted within a housing having a base 25 and a lid 26: the elastomeric elements 24 rest on the shoulders 27 in the base 25 and the lid 26 bears on the elements 24 so that they are lightly gripped between the lid 26 and shoulders 27. The elements 24 are located in recesses 28 of the housing base 25 so that they are constrained against movement lengthwise or sideways relative to the housing. The elastomeric elements 24 may be hollow and/or of alternative shapes e.g. generally hemispherical as shown in Figure 7. The elastomeric elements may be formed by injection moulding directly onto the projections 23 as shown in Figure 8, in which cavities 29 are defined between bottom and top parts 25, 26 of a mould.

In a further modification shown in Figures 9 and 10, each elastomeric element 30 may be in the form of two circular cups arranged back-to-back and lightly gripped between the lid 26 and base 25 of the outer housing. Each element 30 is engaged within a slot in the respective projection 23 from the metal casing 22, the element 30 being formed with an annular locating groove 31. The element 30 may be formed in one-piece as shown in Figure 9 and at (a) in Figure 10, or it may be formed as two pieces 32, 33 as shown at (b) in Figure 10 with one piece 32 having a stem 34 for fitting through a hole in the other piece 33, a top portion of the stem 34 then being broken off, in which case the element is engaged within a circular hole in the projection 23.

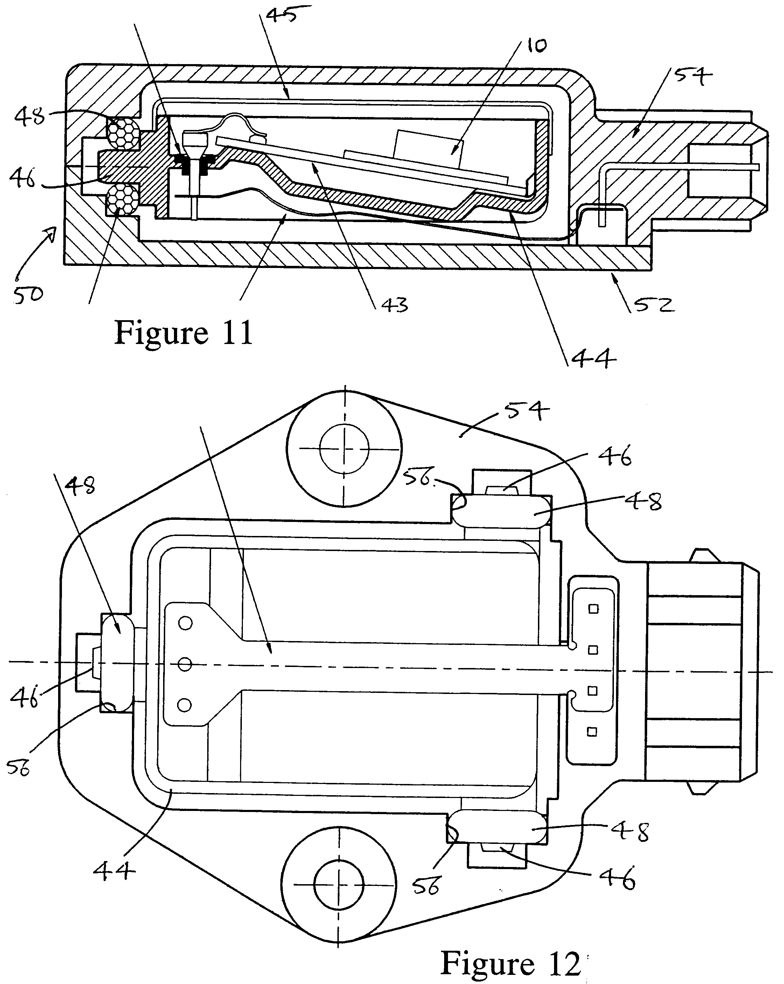

In the embodiment shown in Figures 11 and 12, the acceleration sensor is fixed to a ceramic tile substrate 43 which is mounted within a generally rectangular die-cast casing 44 at the required angle of orientation. The casing 44 is fitted with a lid 45. The casing 44 is formed with a plurality of projections or spigots 46, three in the example shown: thus a first spigot 46 projects from the centre of one end of the casing and the other two spigots project from opposite sides of the casing adjacent the opposite end of the casing. The casing 44 is mounted within a housing 50 by elastomeric O-rings 48 engaged over the respective spigots 46: thus the housing 50 comprises a base 52 and a lid 54 and the O-rings 48 locate within recesses 56 formed in the inner wall of the housing 50, partly in the base 52 and partly in the lid 54. As explained previously, a major advantage of this embodiment derives from the relative ease with which the O-rings can be manufactured to a high degree of concentricity. Also, by die-casting the inner casing 44, good dimensional accuracy can be maintained and the substrate 43 can be mounted to the casing at the required orientation without the use of a packing piece.

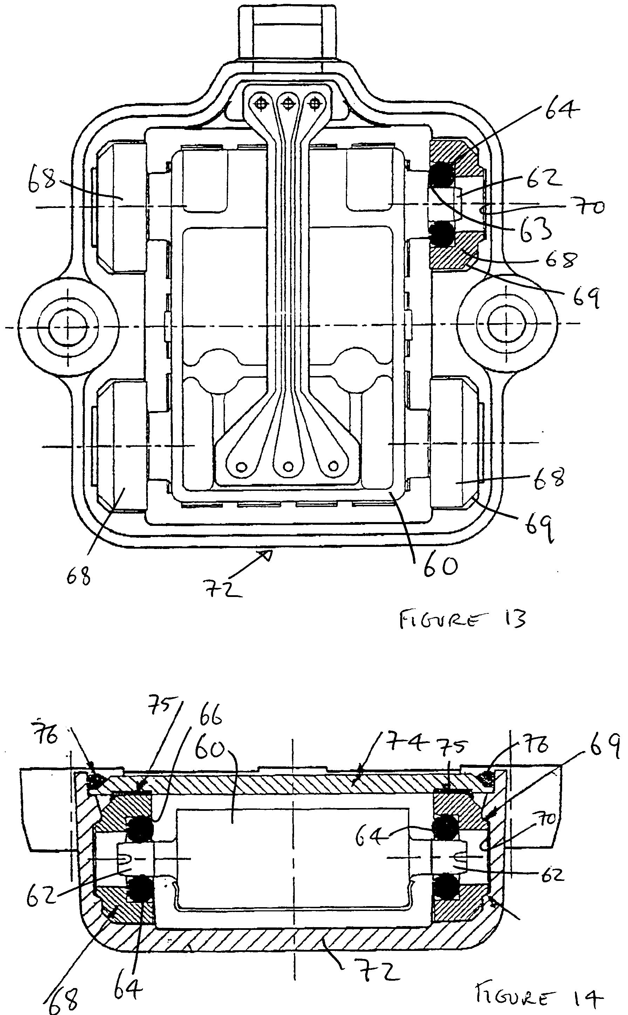

In the embodiment shown in Figures 13 and 14, the substrate, to which the acceleration sensor is mounted, is mounted within a casing 60 which has two projections or spigots 62 extending from each of its opposite sides. Elastomeric O-rings 64 are engaged over the spigots 62 and against shoulders 63 thereon: the O-rings 64 are engaged under light compression within annular recesses 66 in respective annular mounting members 68. The mounting members 68 are tapered on their outer sides 69, to locate within circular recesses 70 in the side walls of the base 72 of the outer housing. During manufacture, the O-rings 64 are engaged over the spigots 62 and then this assembly is fitted into the base 72, for the mounting members 68 to snap-engage into the recesses 70. A lid 74 closes the housing: adhesive at 75 locks the members 68 in position and adhesive at 76 bonds and seals the lid to the base.

In the embodiments which have been described, the elastomeric elements are lightly gripped or compressed between the lid and base of a housing, or in their respective mounting elements in Figures 13 and 14, without the use of any adhesive. In the embodiments of Figures 1 to 7, the elastomeric elements will be subjected to compressive stress only, in response to displacement of the circuit board 13 in any direction. However if desired in certain applications, the elastomeric elements may be connected to the lid and base using adhesive: in the embodiment of Figures 1 to 3, the elastomeric elements may be fixed to the board using adhesive, instead of or in addition to being connected to the lid and body with adhesive. The use of adhesive, particularly at the interface between the circuit board and the elastomeric elements, will modify the resilience of the latter and is therefore dependent upon the application.

In the embodiments which have been described, the elastomeric elements are such that they remain relatively rigid at low values of acceleration (at least along the axis perpendicular to the plane of the board 13) but exhibit substantially greater flexibility at higher values of acceleration. Thus the attenuating or damping effect of the elastomeric elements is not significant at the relatively low values of acceleration but is substantial at the higher values of acceleration (at least along the axis perpendicular to the board). The double cup-shaped elements 30 of Figures 9 and 10 exhibit a particularly advantageous characteristic, in that they retain their shape for accelerations up to a distinct value along the axis perpendicular to the board, but exhibit substantial resilience and attenuation for accelerations above that value.

## Claims

1) A component mounting arrangement, comprising a substrate (13) carrying at least one component (10), a plurality of elastomeric elements (e.g. 16) connected to the substrate and spaced apart around the periphery of the substrate, and a housing (15) having a base portion (17) and a top portion (19) fitted together, the substrate being disposed within the housing with the elastomeric elements connected to the housing.

2) A component mounting arrangement as claimed in claim 1, in which the elastomeric elements (16) are held between the base and top portions (17, 19) of the housing.

3) A component mounting arrangement as claimed in claim 2, in which the elastomeric elements (16) are held under precompression between the base and top portions (17, 19) of the housing, with or without adhesive between the elastomeric elements and the respective housing portions.

4) A component mounting arrangement as claimed in claim 2, in which the elastomeric elements are held, without precompression, between the base and top portions of the housing, being fixed by adhesive between themselves and the respective housing portions or located in recesses defined between the housing portions.

5) A component mounting arrangement as claimed in any preceding claim, in which the elastomeric elements (16) are generally of U-shape and engaged around the edge of the substrate (13).

6) A component mounting arrangement as claimed in any one of claims 1 to 4, comprising a plurality of projections (23) extending outwardly from the substrate or from a casing (22) in which the substrate is mounted, said projections carrying respective said elastomeric elements (24).

7) A component mounting arrangement as claimed in claim 6, in which each elastomeric element is in the form of two cups (32, 33) arranged back-to-back.

8) A component mounting arrangement as claimed in claim 6, in which the elastomeric elements comprise O-rings (48) encircling the respective projections (46) from the substrate or its casing.

9) A component mounting arrangement as claimed in claim 8, in which the O-rings (64) are engaged within recesses in respective mounting elements (68) which are in turn engaged with the housing.

10) A component mounting arrangement as claimed in claim 9, in which the mounting elements (68) are snap-engaged within recesses (70) in opposite side walls of the base portion (72) of the housing.

Figure 1

Figure 3

Figure 2

6

Figure 4

Figure 5

Figure 6

Figure 8

Figure 7

Figure 9

Figure 10

Figure 11

Figure 12

FIGURE 13

FIGURE 14

**European Patent Office**

# EUROPEAN SEARCH REPORT

Application Number

EP 91 30 9625

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | DE-A-3 135 224 (TELDIX)<br>* page 5, line 27 - page 6, line 6; figures 1,2 * <br>--- | 1,5 | H05K5/00<br>F16F15/08<br>G01D11/16 |
| Y | US-A-4 196 467 (JAKOB ET AL)<br>* column 2, line 29 - line 68; figure 1 *<br>--- | 1,5 | |
| A | GB-A-2 186 431 (SPERRY-SUN)<br>* abstract; figure 1 *<br>--- | 1-3 | |
| A | GB-A-2 084 330 (SUNDSTRAND DATA CONTROL)<br>* page 1, line 45 - line 58; figure 3 *<br>----- | 1 | |
| | | | **TECHNICAL FIELDS SEARCHED (Int. Cl.5)**<br><br>G01P<br>H05K<br>G01D<br>FI6F<br>G12B |

The present search report has been drawn up for all claims

| Place of search | Date of completion of the search | Examiner |
|---|---|---|
| THE HAGUE | 22 JANUARY 1992 | JONSSON P. |